# EUROPEAN PATENT SPECIFICATION

(11) **EP 3 828 563 B1**
(45) Date of publication and mention of the grant of the patent: **06.08.2025**
(21) Application number: 20208444.8
(22) Date of filing: 18.11.2020
(51) Int. Cl.: G01R 31/28

(54) **POLISHED TEMPERATURE-CONTROLLED STAGE**
POLIERTE TEMPERATURGEREGELTE BÜHNE
APPAREIL À ÉTAGE POLI ET RÉGULÉ EN TEMPÉRATURE

(30) Priority: 27.11.2019 JP 2019214675
(43) Date of publication of application: 02.06.2021
(73) Proprietor: Tokyo Electron Limited, Tokyo 107-6325 (JP)
(72) Inventor: KOBAYASHI, Dai, Nirasaki City, Yamanashi 407-8511 (JP); NAKAYAMA, Hiroyuki, Nirasaki City, Yamanashi 407-8511 (JP); AKAIKE, Yutaka, Nirasaki City, Yamanashi 407-8511 (JP)
(74) Representative: Diehl & Partner

(56) References cited:
- JP-A- 2013 140 913
- JP-A- 2019 106 491
- US-A1- 2007 024 299
- US-A1- 2007 221 363
- US-A1- 2020 386 805

## Description

### CROSS-REFERENCE TO RELATED APPLICATION

This application is based upon and claims the benefit of priority from Japanese Patent Application No. 2019-214675, filed on November 27, 2019.

### TECHNICAL FIELD

The present disclosure relates to a stage.

### BACKGROUND

Patent Document 1 discloses a placement apparatus including a top plate made of ceramic, a temperature adjustment body having a cooling jacket and a surface heater integrated with the top plate, a heat-insulating plate integrated with the temperature adjustment body via a heat-insulating ring, and a heat-retaining plate ring mounted on outer peripheral surfaces of the above-mentioned components. Both surfaces of the heat-retaining plate ring are formed in a mirror surface shape so that the radiant heat from the top plate, the surface heater, etc. can be easily reflected and the heat radiation amount from the outer surface of the heat-retaining plate ring can be suppressed.
Patent Document 2 discloses a prober for inspecting an imaging device by bringing a probe into electrical contact with a wiring layer of the imaging device, while making light incident on the reverse-side irradiation type imaging device formed on a wafer. A light irradiation mechanism includes a plurality of LEDs.
Patent Document 3 discloses a wafer holding member including a chuck top and a support member therefor having a bottom portion and a cavity portion, wherein the cavity portion contains a cooling mechanism.
Patent Document 4 discloses a wafer holder including a supporting plate and a temperature control unit therefor, the temperature control unit having through holes for supporting columns. Patent Document 5 discloses a mounting apparatus including a temperature control unit integrated with a surface plate. The surface plate is formed of ceramic, and the surface plate and the temperature control unit are coupled to each other.

### [Prior Art Document]

### [Patent Document]

Patent Document 1: JP 2008-066692 A
Patent Document 2: JP 2019-106491 A
Patent Document 3: US 2007/0024299 A1
Patent Document 4: JP 2013-140913 A
Patent Document 5: US 2007/0221363 A1

### SUMMARY

According to an embodiment of the present disclosure, there is provided a stage comprising the combination of features of independent claim 1.

### BRIEF DESCRIPTION OF DRAWINGS

The accompanying drawings, which are incorporated in and constitute a part of the specification, illustrate embodiments of the present disclosure, and together with the general description given above and the detailed description of the embodiments given below, serve to explain the principles of the present disclosure.
FIG. 1 is a view illustrating an exemplary configuration of an inspection apparatus 1.
FIG. 2 is a plan view of the inspection apparatus 1 of FIG. 1.
FIG. 3 is a view illustrating an exemplary configuration of a wafer transport mechanism of the inspection apparatus 1 of FIG. 1.
FIG. 4 is a cross-sectional view illustrating an exemplary configuration of a stage 100 according to an unclaimed example.
FIGS. 5A to 5D are views showing images of surfaces and surface roughness distributions on exemplary processed SiC plates.
FIG. 6 is a cross-sectional view illustrating an exemplary configuration of a stage 100M according to an embodiment.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments. In the specification and drawings, constituent elements that are substantially the same will be denoted by the same reference numerals, and redundant descriptions may be omitted. The following description will be made using a vertical direction or relationship in the drawings, but it does not represent a universal vertical direction or relationship.

### <Embodiment>

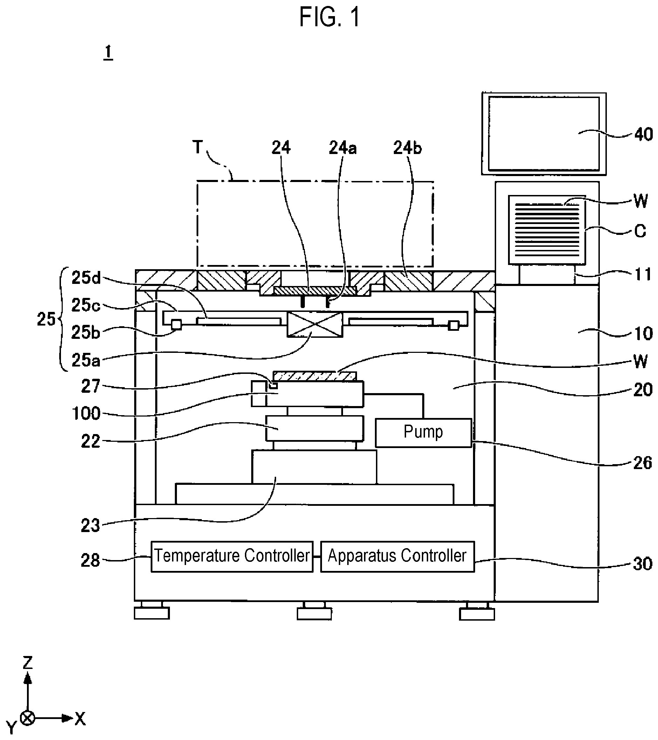

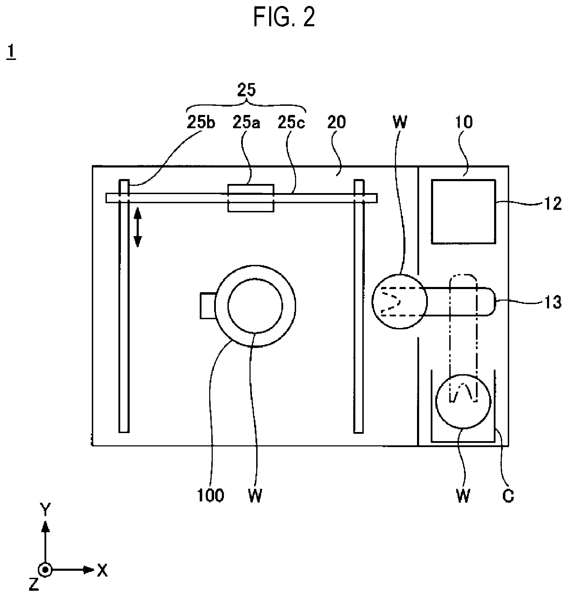

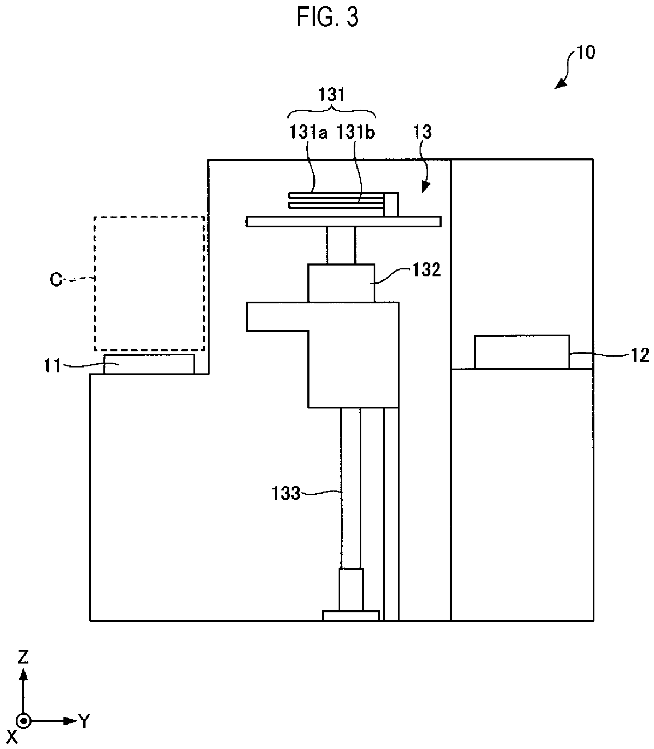

With reference to FIGS. 1 to 3, an inspection apparatus 1 will be described. FIG. 1 is a view illustrating an exemplary configuration of the inspection apparatus 1. FIG. 2 is a plan view of the inspection apparatus 1 of FIG. 1. FIG. 3 is a view illustrating an exemplary configuration of a wafer transport mechanism of the inspection apparatus 1 of FIG. 1.

The inspection apparatus 1 includes a loader part 10, an inspection part 20, and an apparatus controller 30. The inspection apparatus 1 transports a semiconductor wafer (hereinafter, referred to as "wafer W"), which is an inspection object, from the loader part 10 to the inspection part 20 under the control of the apparatus controller 30, and applies an electrical signal to an electronic device formed on the wafer W so as to inspect various electrical properties. In such an inspection, the electronic device formed on the wafer W is a device under test (DUT).

The loader part 10 includes a load port 11, an aligner 12, and a wafer transport mechanism 13.

A cassette C containing a wafer W is placed in the load port 11. The cassette C is, for example, a front opening unified pod (FOUP).

The aligner 12 aligns the wafer W with reference to a cutout such as an orientation flat or a notch formed on the wafer W.

The wafer transport mechanism 13 transports the wafer W among the cassette C placed in the load port 11, the aligner 12, and a stage 100 installed in the inspection part 20 described later. The wafer transport mechanism 13 has an arm unit 131, a rotational driving mechanism 132, and a vertical driving mechanism 133.

The arm unit 131 includes arms 131a and 131b that are installed in two stages in the vertical direction and are independently movable in the horizontal direction. Each of the arms 131a and 131b holds the wafer W.

The rotational driving mechanism 132 is installed below the arm unit 131, and rotates the arm unit 131. The rotational driving mechanism 132 includes, for example, a stepping motor.

The vertical driving mechanism 133 is installed below the rotational driving mechanism 132, and vertically moves the arm unit 131 and the rotational driving mechanism 132. The vertical driving mechanism 133 includes, for example, a stepping motor. The wafer transport mechanism 13 is not limited to the configuration illustrated in FIG. 3, and may have, for example, an articulated arm and a vertical driving mechanism.

In the loader part 10, first, the wafer transport mechanism 13 transports the wafer W accommodated in the cassette C to the aligner 12. Then, the aligner 12 aligns the wafer W. Then, the wafer transport mechanism 13 transports the aligned wafer W from the aligner 12 to the stage 100 installed in the inspection part 20.

The inspection part 20 is arranged adjacent to the loader part 10. The inspection part 20 includes the stage 100, a lifting mechanism 22, an XY stage 23, a probe card 24, an alignment mechanism 25, a pump 26, a temperature sensor 27, and a temperature controller 28.

A wafer W is placed on the top surface of the stage 100. The stage 100 includes, for example, a vacuum chuck or an electrostatic chuck. The stage 100 has a coolant flow path, and a coolant such as water or Galden (registered trademark) is supplied from the pump 26 to the coolant flow path. As a result, the stage 100 is cooled.

The lifting mechanism 22 is provided below the stage 100, and moves the stage 100 up and down with respect to the XY stage 23. The lifting mechanism 22 includes, for example, a stepping motor.

The XY stage 23 is installed below the lifting mechanism 22, and moves the stage 100 and the lifting mechanism 22 in two axial directions (the X direction and Y direction in the drawing). The XY stage 23 is fixed to the bottom of the inspection part 20. The XY stage 23 includes, for example, a stepping motor.

The probe card 24 is arranged above the stage 100. A plurality of probes 24a is disposed on the stage 100 side of the probe card 24. The probe card 24 is detachably attached to the head plate 24b. A tester (not illustrated) is connected to the probe card 24 via a test head T.

The alignment mechanism 25 includes a camera 25a, a guide rail 25b, an alignment bridge 25c, and a light source 25d. The camera 25a is attached to the center of the alignment bridge 25c to face downward, and captures an image of, for example, the stage 100 and the wafer W. The camera 25a is, for example, a CCD camera or a CMOS camera. The guide rail 25b supports the alignment bridge 25c so as to be movable in the horizontal direction (the Y direction in the drawing). The alignment bridge 25c is supported by a pair of left and right guide rails 25b, and moves in the horizontal direction (the Y direction in the drawing) along the guide rails 25b. As a result, the camera 25a moves between a standby position and a position directly below the center of the probe card 24 (hereinafter, referred to as a "probe center") via the alignment bridge 25c. During alignment, the camera 25a located at the probe center captures an image of electrode pads of the wafer W on the stage 100 from above while the stage 100 is moving in the XY directions, and performs image processing so as to display a captured image on the display device 40. The light source 25d is installed below the alignment bridge 25c and emits light to the stage 100. The light source 25d is, for example, an LED light source in which a large number of light-emitting diodes (LEDs) are arranged, and emits light when an image of the wafer W is captured by the camera 25a. The light source 25d is used as illumination during image capturing.

The alignment mechanism 25 moves the camera 25a to the standby position when the alignment of the wafer W in the XY directions is completed. When the camera 25a is located at the standby position, the camera 25a is not present directly below the probe card 24, and is offset in the Y direction. In this state, when the lifting mechanism 22 raises the stage 100 with respect to the XY stage 23, the plurality of probes 24a comes into contact with the electrode pads of the wafer W on the stage 100, thereby being brought into the state in which an inspection of electrical characteristics of electronic devices on the wafer W can be performed. The probe 24a is an example of contact terminals.

The pump 26 is, for example, a mechanical pump that pumps the coolant. The coolant output from the pump 26 is circulated between the pump 26 and the coolant flow path in the stage 100. The coolant is, for example, water or Galden (registered trademark), which is a colorless and light-transmissive liquid.

The temperature sensor 27 detects the temperature of the stage 100. The temperature sensor 27 is, for example, a thermocouple embedded in the stage 100.

The temperature controller 28 is provided below the stage 100. The temperature controller 28 is, for example, a computer. The temperature controller 28 executes a temperature control method including a step of detecting the temperature of the stage 100 by the temperature sensor 27, and a step of performing lighting control of an LED module of the stage 100 and driving control of the pump 26 based on the temperature of the stage 100 detected by the temperature sensor 27.

When inspecting the electrical characteristics of electronic devices on the wafer W, the wafer W is pressed upward by the lifting mechanism 22 in order to ensure electrical contact between the probes 24a and the electrode pads of the wafer W. That is, the probes 24a are pressed against the electrode pads on the wafer W by applying a load. In this case, a load of about 1 g to about 5 g may be applied to each probe 24a.

For example, if a load of about 1 g to about 5 g is applied to each probe 24a when inspecting one electronic device of a 30 mm square (30 mm long×30 mm wide in a plan view) included in the wafer W, a load of about 100 kg to several hundreds of kg or more may be applied to the wafer W when the numbers of the probes 24a and electrode pads are large.

For this reason, the stage 100 is required to have high rigidity capable of withstanding the above-described load and to have a high load-resistant strength, and thus to have little displacement caused by deformation.

During the inspection of the electrical characteristics, the heat generation amount of one electronic device (DUT) may become, for example, about 100 W to several hundreds of W or more. Therefore, the stage 100 is required to have a cooling (heat-absorbing) structure and a heating structure for adjusting the temperature of the electronic devices within a predetermined temperature range (e.g., within ±3 degrees C) with respect to a set temperature in the inspection. In order to keep an electronic device having a large quantity of heat within a predetermined temperature range with respect to the set temperature, it is necessary to perform heat absorption and heating at high speed. Thus, the stage 100 is required to have a small heat capacity and a high thermal conductivity. In recent years, since the quantity of heat in electronic devices has tended to increase, there is an increasing demand for, especially, an increase in an endothermic amount.

Details of the stage 100 of the embodiment, which meets the requirements described above will be described below.

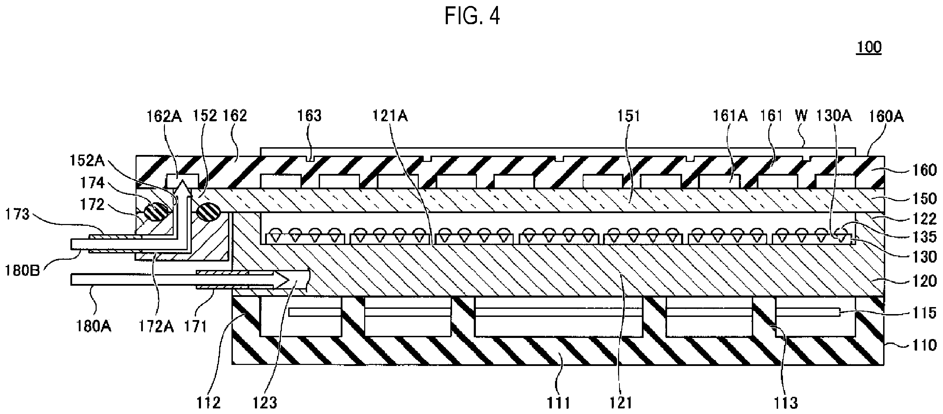

FIG. 4 is a cross-sectional view illustrating an exemplary configuration of a stage 100 of an unclaimed example. The stage 100 includes a base plate 110, a control board 115, a middle plate 120, an LED module 130, a glass plate 150, a top plate 160, a pipe 171, a connecting portion 172, a pipe 173, and an O-ring 174.

Hereinbelow, a description will be made with reference to a vertical direction in the drawing. Further, the term "in a plan view" means "viewed from above to below in a plane".

The base plate 110 is a circular member serving as a base (base stage) of the stage 100 and having a circular shape in a plan view, and is made of, for example, ceramic such as alumina (Al₂O₃). The base plate 110 has a disk-shaped base portion 111, an outer peripheral wall 112 protruding upward along the outer periphery thereof, and a holding portion 113 protruding from the top surface of the base portion 111.

The upper end of the outer peripheral wall 112 is fixed to the bottom surface of the middle plate 120, and the holding portion 113 holds the control board 115 and the middle plate 120. In the state in which the middle plate 120 is fixed on the base plate 110, the space surrounded by the base portion 111, the outer peripheral wall 112, and the middle plate 120 is closed. The control board 115 is arranged in this space.

The control board 115 is a wiring board on which, for example, a microcomputer (not illustrated) that performs, for example, lighting control of the LED module 130 is mounted. The control board 115 is connected to the temperature controller 28 (see FIG. 1) via, for example, a wire (not illustrated).

The middle plate 120 is a member arranged on the base plate 110 and having a circular shape in a plan view, and is made of, for example, copper (Cu). As an example, the middle plate 120 is fixed on the base plate 110 by, for example, screwing. The middle plate 120 is an example of a first cooling plate.

The middle plate 120 has a disk-shaped base portion 121, an outer peripheral wall 122 protruding upward along the outer periphery, and a coolant flow path 123. The coolant flow path 123 is an example of a first coolant flow path. The middle plate 120 is provided with a through hole (not illustrated) through which a wire connecting the control board 115 and the LED module 130 to each other passes. The through hole penetrates the middle plate 120 so as to connect the top surface and the bottom surface of the middle plate 120.

A plurality of LED modules 130 is mounted on the top surface of the base portion 121. In addition, the upper end of the outer peripheral wall 122 is fixed to the glass plate 150 using, for example, an adhesive.

The space above the base portion 121 is the mounting portion of the LED module 130. Since the height of the outer peripheral wall 122 with respect to the base portion 121 is higher than the height of the LED module 130, there is a space between the LED module 130 and the glass plate 150 mounted on the base portion 121.

FIG. 4 illustrates only a portion of the coolant flow path 123. However, in order to cool the LED module 130, the coolant flow path 123 is actually installed inside the base portion 121 to cover substantially the entire base portion 121 in a plan view. A coolant 180A is supplied to the coolant flow path 123 via a pipe 171 as indicated by an arrow. As the coolant 180A, for example, water or Galden (registered trademark) may be used, and the coolant may be supplied to the coolant flow path by the pump 26 (see FIG. 1).

Each LED module 130 has a plurality of LEDs 130A and lenses 135 attached to each LED 130A. The LED module 130 is an example of a heating source, and the LED 130A is an example of a light-emitting element. As the LED 130A, an LED that outputs near infrared light may be used. The lens 135 is attached to the light output portion of each LED 130A. The lens 135 is installed for adjusting the directivity of the light output from the LED 130A so as to suppress the dispersion of the light, thereby narrowing an emitting range. The lens 135 is made of, for example, glass or resin.

The LED module 130 is installed to heat the wafer W placed on the top plate 160 in order to adjust the temperature of the wafer W. The light (near infrared light) output from each LED 130A of the LED module 130 passes through the glass plate 150 and is absorbed into the top plate 160, thereby heating the top plate 160. As a result, the wafer W placed on the top surface of the top plate 160 can be heated.

The glass plate 150, which is an example of a transmission member, is provided on the outer peripheral wall 122 of the middle plate 120, and is fixed to the upper end of the outer peripheral wall 122 by, for example, an adhesive. A space is formed between the glass plate 150 and the LED module 130. The glass plate 150 has a disk-shaped base portion 151 and a protrusion 152 protruding from the base portion 151 in a plan view. The top plate 160 is arranged on the glass plate 150. The glass plate 150 and the top plate 160 are bonded to each other.

When the top plate 160 is placed on the glass plate 150, the base portion 151 covers a groove 161A formed in the bottom surface side of the top plate 160 from below, and the protrusion 152 covers the groove 162A formed in the bottom surface side of the top plate 160 from below. As a result, the grooves 161A and 162A serve as a coolant flow path.

A connecting portion 172 is fixed to the bottom surface of the protrusion 152 via a rubber O-ring 174 by, for example, screwing. The protrusion 152 has a through hole 152A that communicates with the coolant flow path 172A in the connecting portion 172. The through hole 152A communicates with the groove 162A in the top plate 160.

The glass plate 150 is transparent in order to efficiently guide the light output from the LED module 130 to the top plate 160. As the glass plate 150, heat-resistant glass may be used such that it can withstand the heat generated by the wafer W and the heat generated by the nearinfrared light of the LED module 130. For example, TEMPAX Float (registered trademark) may be used.

In the embodiment, a mode in which the glass plate 150 is used as an example of the transmission member has been described, but a transparent resin plate may be used instead of the glass plate 150. As the transparent resin plate, for example, an acrylic or polycarbonate resin plate may be used.

The top plate 160 has the same shape as the glass plate 150 in a plan view, and has a placement surface 160A, a disk-shaped base portion 161, a protrusion 162 protruding from the base portion 161 in a plan view, and a vacuum chuck 163. The top plate 160 is an example of a second cooling plate. The placement surface 160A is the top surface of the top plate 160, and the wafer W is placed on the placement surface 160A. Here, the shape configuration and function of the top plate 160 will be described first, and the material and thickness of the top plate 160 will be described later.

The top plate 160 has the groove 161A on the bottom surface side of the base portion 161, and has the groove 162A on the bottom surface side of the protrusion 162. The grooves 161A and 162A are formed so as to be recessed upward from the bottom surfaces of the base portion 161 and the protrusion 162. The grooves 161A and 162A are covered with the glass plate 150 from the bottom surface side so as to serve as a coolant flow path. The grooves 161A and 162A are an example of a second coolant flow path.

The groove 161A is formed in a predetermined pattern (e.g., a spiral pattern) in the entire base portion 161 in a plan view, and all of the plurality of grooves 161A in the cross section illustrated in FIG. 4 communicates with each other and communicate with the groove 162A provided in the protrusion 162.

Therefore, as indicated by the arrow, the coolant 180B flows into the groove 162A from the pipe 173 via the coolant flow path 172A in the connecting portion 172 and the through hole 152A in the glass plate 150, flows into the grooves 161A from the groove 162A, and is discharged to the outside of the stage 100 via a discharge groove (not illustrated) similar to the groove 162A.

As the coolant 180B, for example, water or Galden (registered trademark), which is a colorless and light-transmissive liquid, is used, and is supplied to the coolant flow path by a pump (not illustrated) installed outside the inspection apparatus 1 (see FIGS. 1 to 3).

Since the bottom surface of the coolant flow path implemented by the grooves 161A and 162A is the glass plate 150, the coolant 180B passes through the optical path of the light output from the LED module 130. Therefore, a transparent coolant is preferable as the coolant 180A. This is to reduce the attenuation of light caused due to the coolant 180A such that more light output from the LED module 130 reaches the top plate 160, thereby improving the heating efficiency.

The vacuum chuck 163 is installed on the placement surface 160A. A plurality of grooves illustrated as the vacuum chuck 163 in FIG. 4 is connected to a vacuum pump (not illustrated) through a vacuum pipe (not illustrated). By driving the vacuum pump, a wafer W can be suctioned to the placement surface 160A by the vacuum chuck 163.

Further, the top plate 160 has a passage (not illustrated) through which a wire for the temperature sensor 27 (see FIG. 1) for measuring the temperature of the wafer W passes, in addition to the components described above. Such a passage is formed inside the base portion 161 and the protrusion 162 while avoiding a vacuum pipe (not illustrated) connected to the grooves 161A and 162A and the vacuum chuck 163.

In the inspection apparatus 1 including such a stage 100, for example, when one of a plurality of electronic devices formed on the wafer W is selected as an inspection object so as to inspect electrical characteristics, the inspection may be performed as follows. In the state in which the wafer W is suctioned to the placement surface 160A by the vacuum chuck 163, the wafer W is moved upward by the lifting mechanism 22, and a load is applied to the electrode pads on the wafer W to press the probes 24a. Then, the LED module 130 located just below the electronic device, which is an inspection object, outputs light directly upward, and the coolant 180B is caused to flow through the coolant flow path constituted by the grooves 161A and 162A. At this time, the coolant 180A is caused to flow through the coolant flow path 123 in order to cool the LED module 130.

The light output from the LED module 130 heats a portion of the top plate 160 located below the electronic device, which is an inspection object, such that the temperature of the electronic device of the inspection object becomes the set temperature in the inspection. As a result, the electronic device of the inspection object is heated. The electronic device itself generates heat when current flows therethrough. Thus, when the temperature of the electronic device becomes higher than the set temperature, the LED module 130 is turned off and the coolant 180B is supplied so as to absorb heat, thereby lowering the temperature of the electronic device.

Further, when the temperature of the electronic device becomes lower than the set temperature, the LED module 130 may be turned on and the supply of the coolant 180B may be stopped and heated so as to raise the temperature of the electronic device. By performing the control of turning-on and turning-off of the LED module 130 and the control of the supply amount of the coolant 180B at high speed, the temperature of the electronic device of the inspection object is adjusted to be within a predetermined temperature range (e.g., within ±3 degrees C) with respect to the set temperature in the inspection.

Next, the material and thickness of the top plate 160 will be described. The top plate 160 is made of ceramic. The ceramic forming the top plate 160 is, for example, silicon carbide (SiC), a composite material of silicon carbide (SiC) and silicon (Si), or aluminum nitride (AlN). Here, a mode in which the ceramic is silicon carbide (SiC) will be described.

The reason why the above-mentioned ceramic is used as the top plate 160 is to obtain higher rigidity and higher thermal conductivity than those made of metal such as copper or aluminum. The high rigidity can provide a structure that can withstand the load during the inspection of the electrical characteristics (the structure advantageous in load resistance). Further, the high thermal conductivity can make it possible to cope with the heating of the wafer W and the heat absorption from the wafer W, which are performed at high speed during the inspection of the electrical characteristics.

The thickness of the top plate 160 is, for example, 3 mm to 10 mm. The thickness of the top plate 160 is the thickness of the portion in which the grooves 161A and 162A are not formed. The top plate 160 is formed to have a small thickness in order to realize a structure having a small heat capacity. This is because if the heat capacity is small, the temperature of the top plate 160 is easily raised by heating with the LED module 130, and the temperature of the top plate 160 is easily lowered by the flow of the coolant 180B. Further, this is to make the structure capable of coping with the heating of the wafer W and the heat absorption from the wafer W, which are performed at high speed during the inspection of the electrical characteristics.

As described above, the top plate 160, which has a three-dimensional structure including grooves 161A and 162A for cooling, a vacuum chuck 163, and a passage for passing the wire for the temperature sensor, and a thin thickness, is a member, which is considerably difficult to manufacture.

Further, the placement surface 160A of the top plate 160 is mirror-polished, and a maximum height Rmax of the surface roughness (maximum peak to valley roughness height) of the placement surface 160A is, for example, 0.025 µm to 0.2 µm. The mirror polishing process is implemented, for example, by polishing the placement surface 160A of the top plate 160 with a polishing apparatus using slurry (suspension) containing polishing particles.

A load analysis showed that the top plate 160 having the above-described three-dimensional structure and a small thickness does not have sufficient load resistance when the top plate 160 is made of a metal such as aluminum or copper. In addition, it was possible to achieve high flatness of, for example, a level of 0.025 µm to 0.2 µm at the maximum height Rmax on the placement surface 160A by mirror polishing because the top plate 160 was made of ceramic that is highly rigid and is advantageous in load resistance.

Mirror polishing is performed to flatten the placement surface 160A and to reduce contact thermal resistance through top plate 160, the placement surface 160A on which the wafer W is placed, and the bottom surface of the wafer W. Therefore, the maximum height Rmax of the placement surface 160A on which the wafer W is placed is set to be within the range described above. The contact thermal resistance is a resistance value obtained by dividing a surface temperature difference ΔT of two objects by a heat flow rate Q when the two objects having different temperatures (here, the top plate 160 and the wafer W) are brought into contact with each other.

During the inspection of the electrical characteristics, the wafer W is placed on the placement surface 160A, the contact thermal resistance between the top plate 160 and the wafer W through the placement surface 160A and the bottom surface of the wafer W is reduced to perform the heating of the wafer W and the absorption of heat from the wafer W at high speed. Therefore, heat is easily transferred between the top plate 160 and the wafer W.

When the contact thermal resistance between the top plate 160 and the wafer W is large, if the quantity of heat in an electronic device of the inspection object is large, the cooling performed by the heat absorption cannot reach the quantity of heat in the electronic device of the inspection object. Thus, the temperature of the electronic device rises too high and cannot be adjusted within a predetermined temperature range. On the contrary, when the contact thermal resistance between the top plate 160 and the wafer W is large, if it is desired to rapidly heat the electronic device of the inspection object, the heat transfer from the top plate 160 to the wafer W is delayed. Thus, the temperature of the electronic device is too low and cannot be adjusted within a predetermined temperature range. In order to suppress these problems, the placement surface 160A is mirror-polished to reduce the contact thermal resistance between the top plate 160 and the wafer W.

In order to quickly control the temperature of a wafer W having a quantity of heat of, for example, about 100 W to several hundreds of W or more, heating and heat absorption may be switched at high speed. Thus, the small contact thermal resistance between the top plate 160 and the wafer W is very significant. From this point of view, the placement surface 160A of the top plate 160 is mirror-polished to set the maximum height Rmax of the placement surface 160A to, for example, 0.025 µm to 0.2 µm. Since the bottom surface of the wafer W has the maximum height of, for example, about 0.025 µm to 0.2 µm and is sufficiently flat, mirror polishing is performed on the placement surface 160A.

The larger the contact area between the placement surface 160A of the top plate 160 and the bottom surface of the wafer W, the smaller the contact thermal resistance between the top plate 160 and the wafer W. When the maximum height Rmax of the placement surface 160A is within a small value range of, for example, 0.025 µm to 0.2 µm, the area of the contact portion increases, and the gap between the placement surface 160A and the bottom surface of the wafer W decreases. Thus, sufficiently small contact thermal resistance is obtained. When the area of the contact portion increases, the suction force of the vacuum chuck 163 becomes strong, and thus the misalignment (contact misalignment) of the probe 24a with respect to the electrode pads of the electronic device is difficult to occur when a high load is applied.

Here, the following simulation was performed before setting the lower limit value and the upper limit value of the maximum height Rmax of the placement surface 160A to the values described above.

First, the maximum height Rmax of the placement surface 160A of the top plate 160 was examined by simulation.

The target value of the maximum height Rmax of the mirror-polished placement surface 160A of the top plate 160 was set to 0.12 µm or less, and the contact thermal resistance when the maximum height Rmax was 0.12 µm was obtained. As simulation conditions, the thermal conductivity of the top plate 160 was set to 540 W/mK, the maximum height Rmax of the bottom surface of the wafer W was set to 0.1 µm, the size of the electronic device was set to 30 mm×30 mm, the thermal conductivity of the wafer W was set to 157 W/mK, and the load applied to the wafer W was set to 300 kgf.

As a result, the contact thermal resistance between the wafer W and the top plate 160 having the mirror-polished placement surface 160A was 0.024 degrees C/W. This indicates that, when a quantity of heat of 100 W is applied to the top plate 160, the temperature difference ΔT between the top plate 160 and the wafer W is 2.4 degrees C, which is a good result.

In addition, a simulation was performed using a top plate having a top surface, which was not mirror-polished, as a comparative top plate, and the following conditions were set. The maximum height Rmax of the top surface of the comparative top plate was set to 0.8 µm, the thermal conductivity of the comparative top plate was set to 540 W/mK, the maximum height Rmax of the bottom surface of the wafer W was set to 0.2 µm, and the size of the electronic device was set to 30 mm×30 mm, the thermal conductivity of the wafer W was set to 157 W/mK, and the load applied to the wafer W was set to 300 kgf.

As a result, the contact thermal resistance between the comparative top plate and the wafer W was 0.095 degrees C/W. This indicates that when the heat quantity of 100 W is applied to the comparative top plate, the temperature difference ΔT between the comparative top plate and the wafer W is 9.5 degrees C, which is a value at a level at which it is difficult to control heating and heat absorption of the wafer W.

From the above simulations, it was found that when the top plate 160 having the mirror-polished placement surface 160A, the contact thermal resistance was about 1/4 of that obtained in the case in which the comparative top plate was used. From this result, the target value of the contact thermal resistance between the top plate 160 and the wafer W was set to 0.03 degrees C/W or less. Then, the following tests were conducted.

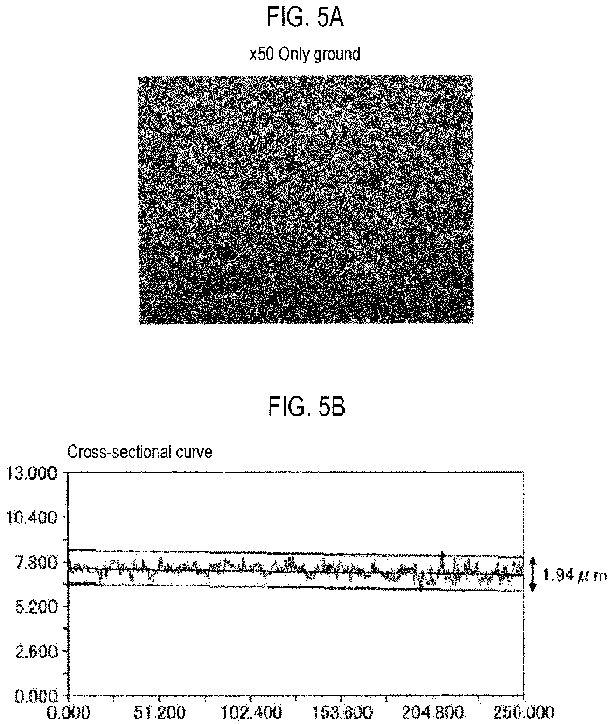

FIGS. 5A to 5D are views showing images of surfaces and surface roughness distributions (cross-sectional curves) on exemplary processed SiC plates.

FIG. 5A shows an image of the surface of a SiC plate, on which a grinding process is performed, taken at a magnification of 50 times using an electron microscope, and FIG. 5B shows a surface roughness distribution (a cross-sectional curve) of the surface of a SiC plate on which a grinding process is performed. The grinding was performed by a grinder using a grinding wheel. As shown in FIG. 5A, the surface was rough, and as shown in FIG. 5B, the maximum height Rmax (the difference between the highest peak and the lowest valley) was 1.94 µm as indicated by the double-headed arrow.

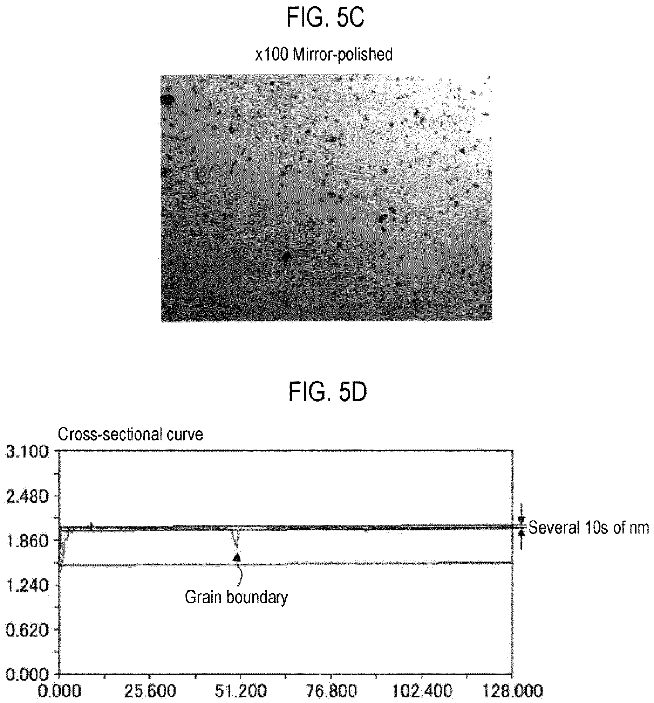

In addition, FIG. 5C shows an image of the surface of a mirror-polished SiC plate taken at a magnification of 100 times using an electron microscope, and FIG. 5D shows a surface roughness distribution (a cross-sectional curve) of the surface of a mirror-polished SiC plate. As shown in FIG. 5C, the surface is very flat, and concave portions due to grain boundaries are visible. Further, as shown in FIG. 5D, the maximum height Rmax was at a level of about several tens of nm, and a value of 0.1 µm or less was obtained. In the measurement of the maximum height Rmax on the mirror-polished surface, the concave portions due to the SiC grain boundary were excluded.

As described above, when the SiC plate is mirror-polished, a maximum height Rmax of 0.1 µm or less is obtained. Therefore, the lower limit of the maximum height Rmax of the placement surface 160A of the top plate 160 was set to 0.025 µm.

In addition, the upper limit of the maximum height Rmax of the placement surface 160A of the top plate 160 was determined as follows. When the contact thermal resistance between the top plate 160 and the wafer W is 0.03 degrees C/W, which is the upper limit of the target range, the temperature difference ΔT between the top plate 160 and the wafer W when a heat quantity of 100 W is applied to the top plate 160 (in this case, the temperature difference ΔT due to the temperature of the top plate 160 being higher than the temperature of the wafer W) is 3 degrees C.

In the case in which the maximum height Rmax of the bottom surface of the wafer W was 0.1 µm and the maximum height Rmax of the placement surface 160A of the top plate 160 was 0.1 µm, when the conductivity of the gas (air) interposed between the wafer W and the top plate 160 was assumed as 0.01 W/mK, the contact thermal resistance was calculated as 0.020 degrees C/W. The calculation was performed in the state in which the contact area between the electronic device and the probe 24a to was set to 30 mm×30 mm and the load applied to the electronic device was set to 300 kg.

In the case in which the maximum height Rmax of the bottom surface of the wafer W was 0.1 µm and the maximum height Rmax of the placement surface 160A of the top plate 160 was 0.2 µm, when the conductivity of the gas (air) interposed between the wafer W and the top plate 160 was assumed as 0.01 W/mK, the contact thermal resistance was calculated as 0.029 degrees C/W. The calculation was performed in the state in which the contact area between the electronic device and the probe 24a to was set to 30 mm×30 mm and the load applied to the electronic device was set to 300 kg.

Thus, when the maximum height Rmax of the placement surface 160A of the top plate 160 was set to 0.2 µm, the contact thermal resistance was about 0.03 degrees C/W. Therefore, the upper limit of the maximum height Rmax of the placement surface 160A of the top plate 160 was set to 0.2 µm.

As described above, since the stage 100 is highly rigid by being made of ceramic and includes the top plate 160 having the mirror-polished placement surface 160A, the contact thermal resistance between the top plate 160 and the wafer W through the placement surface 160A and the bottom surface of the wafer W is reduced. Reduction of the contact thermal resistance between the top plate 160 and the wafer W means reduction of the contact thermal resistance between the stage 100 and the wafer W.

Therefore, according to the embodiment, it is possible to provide the stage 100 and the inspection apparatus 1, which are capable of reducing the contact thermal resistance between the stage 100 and the wafer W. In addition, since the contact thermal resistance between the stage 100 and the wafer W is low, it is possible to perform the heating of the wafer W and the absorption of heat from the wafer W at high speed, and thus to perform the inspection with high throughput.

Further, since the top plate 160 is made of ceramic and has high rigidity, it is possible to obtain good flatness in mirror polishing even if the top plate 160 is made thin in order to reduce the heat capacity. The top plate 160 made of ceramic is advantageous in load resistance compared with that made of metal.

Further, since the top plate 160 vacuum-suctions the wafer W using the vacuum chuck 163, the attraction force between the top plate 160 and the wafer W becomes stronger when the contact thermal resistance between the top plate 160 and the wafer W is reduced by performing mirror polishing on the placement surface 160A (i.e., when the space gap becomes small). As a result, the misalignment (contact misalignment) of the probes 24a with respect to the electrode pads of the electronic device is difficult to occur when a high load is applied.

Further, since the maximum height Rmax of the placement surface is 0.025 µm to 0.2 µm, the contact thermal resistance between the top plate 160 and the wafer W becomes 0.020 degrees C/W to about 0.03 degrees C/W. Therefore, it is possible to provide the stage 100 having a configuration capable of performing heating of the wafer W and absorption of heat from the wafer W at high speed.

Further, since the thickness of the top plate 160 is 3 mm to 10 mm, it is possible to provide the stage 100 in which the rigidity of the top plate 160 is ensured and the heat capacity is reduced.

Further, the ceramic forming the top plate 160 is made of, for example, silicon carbide (SiC), a composite material of silicon carbide (SiC) and silicon (Si), or aluminum nitride (AlN). Thus, it is possible to provide the stage 100 including the top plate 160, which is more rigid than metal and has a placement surface 160A suitable for mirror polishing.

In the above description, the mode in which a wafer W having a plurality of electronic devices formed thereon is placed on the top plate 160 has been described. However, a plurality of electronic devices separated by dicing may be placed on the placement surface 160A of the top plate 160 in the state of being arranged on a predetermined substrate.

In the above description, the mode in which the base portion 111 of the base plate 110, the base portion 121 of the middle plate 120, the base portion 151 of the glass plate 150, and the base portion 161 of the top plate 160 are disk-shaped has been described. However, the base portions 111, 121, 151, and 161 may be rectangular plate-shaped members in a plan view. In this case, the outer peripheral wall 122 of the middle plate 120 may be a rectangular wall in a plan view.

In the foregoing, the configuration in which the top plate 160 has the grooves 161A and 162A on respective bottom surface sides of the base portion 161 and the protrusion 162, and the coolant flow path is obtained by covering the grooves 161A and 162A using the glass plate 150 from the bottom surface sides thereof has been described above. However, the top plate 160 may have a coolant flow path provided inside the top plate 160 instead of the grooves 161A and 162A. This coolant flow path is located between the top surface and the bottom surface in the vertical direction (thickness direction) of the top plate 160.

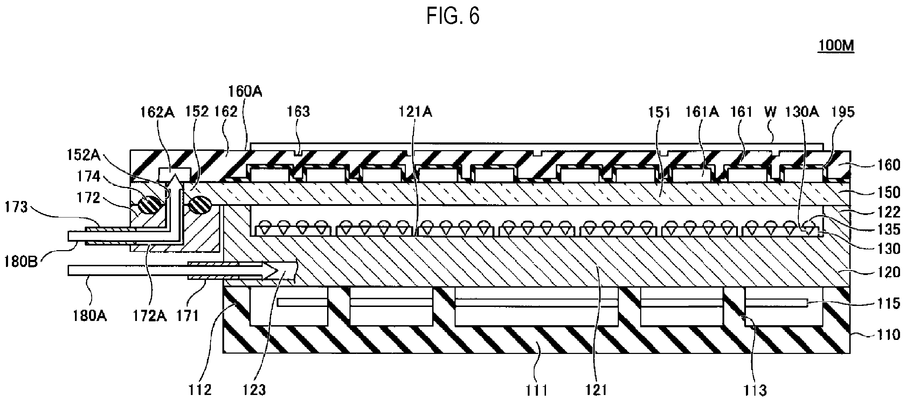

FIG. 6 is a cross-sectional view illustrating an exemplary configuration of a stage 100M according to an embodiment. The stage 100M is obtained by applying a black coating 195 to the bottom surface of the top plate 160 of the stage 100 (shown in FIG. 4) of the unclaimed example.

The black coating 195 is an example of a heat absorption film, and is applied to the inside of the groove 161A in the base portion 161 of the top plate 160 and the portions that are in contact with the glass plate 150. The black coating 195 is provided in order to more efficiently absorb the light, which is output from the LED module 130 and transmitted through the glass plate 150, on the bottom surface of the top plate 160, and to more efficiently heat the top plate 160. By applying this black coating 195, it is possible to more efficiently heat the electronic devices on a wafer W.

As the black coating 195, a water-based paint or a fluororesin coating containing black ceramic powder having water resistance and heat resistance may be applied. The top plate 160 having the black coating 195 applied thereto may be bonded onto the glass plate 150.

As described above, according to the embodiment, by applying the black coating 195 to the bottom surface of the top plate 160, it is possible to provide the stage 100M, which is capable of improving heating efficiency by more efficiently absorbing heat into the top plate 160, in addition to suppressing the displacement of the top plate 160 due to a load.

In the embodiment, the mode in which the black coating 195 as an example of the heat absorption film is applied to the bottom surface of the top plate 160 has been described. However, the film is not limited to the black coating 195 as long as the film is capable of increasing the amount of the heat absorption of the top plate 160. The color may be other than black (e.g., dark gray), and the material of the heat absorption film may be other than those described above.

According to an aspect, it is possible to reduce the contact thermal resistance between the stage on which an inspection object is placed and the inspection object.

## Claims

1. A stage (100, 100M) configured to hold thereon an inspection object (W) having an electronic device pressed against a contact terminal (24a) of a probe card (24) of an inspection apparatus (1) by applying a load, and including a first cooling plate (120) including a first coolant flow path (123) formed in the first cooling plate (120),
a heating source (130) mounted on the first cooling plate (120) and configured to heat the inspection object (W), and
a transmission member (150) installed on the heating source (130) and configured to transmit light output from the heating source (130); the stage (100, 100M) being **characterized by**:
a second cooling plate (160) installed on the transmission member (150), including a placement surface (160A) configured to vacuum-suction the inspection object (W) and a second coolant flow path (161A, 162A), made of ceramic, and subjected to a mirror polishing process on the placement surface (160A); and
a heat absorption film (195) installed on a bottom surface of the second cooling plate (160) and formed by applying a water-based paint or a fluororesincontaining ceramic powder having water resistance and heat resistance,
wherein the placement surface (160A) of the second cooling plate (160) has a maximum height (Rmax) of the surface roughness of 0.025 µm to 0.2 µm,
wherein the second coolant flow path (161A, 162A) is formed inside the second cooling plate (160),
wherein the second cooling plate (160) has a thickness of 3 mm to 10 mm, and wherein the ceramic forming the second cooling plate (160) is silicon carbide, a composite material of silicon carbide and silicon, or aluminum nitride.

## Patentansprüche

1. Bühne (100, 100M), die dazu ausgebildet ist, ein Untersuchungsobjekt (W) darauf zu halten, das ein elektronisches Gerät durch Beaufschlagen mit einer Last gegen einen Kontaktanschluss (24a) einer Sondenkarte (24) einer Untersuchungsvorrichtung (1) drückt, und die
eine erste Kühlplatte (120) mit einem in der ersten Kühlplatte (120) gebildeten ersten Kühlmittel-Strömungspfad (123),
eine an der ersten Kühlplatte (120) montierte und zum Heizen des Untersuchungsobjekts (W) ausgebildete Heizquelle (130), und
ein an der Heizquelle (130) installiertes und zum Übertragen von von der Heizquelle (130) ausgegebenem Licht ausgebildetes Übertragungsbauteil (150) beinhaltet;
wobei die Bühne (100, 100M) **gekennzeichnet ist durch**:
eine zweite, an dem Übertragungsbauteil (150) installierte Kühlplatte (160), die eine Positionieroberfläche (160A) aufweist, die dazu ausgebildet ist, das Untersuchungsobjekt **durch** Vakuum anzusaugen, und einen aus Keramik gebildeten zweiten Kühlmittel-Strömungspfad (161A, 162A), der auf der Positionieroberfläche (160A) einem Spiegelpolierprozess unterzogen wurde; und
einen an einer Bodenfläche der zweiten Kühlplatte (160) installierten Wärmeabsorptionsfilm (195), der **durch** Auftragen einer wasserbasierten Farbe oder eines Fluorharz-enthaltenden Keramikpulvers mit Wasserbeständigkeit und Hitzebeständigkeit gebildet ist,
wobei die Positionieroberfläche (160A) der zweiten Kühlplatte (160) eine maximale Rautiefe (Rmax) der Oberflächenrauigkeit von 0,025 µm bis 0,2 µm aufweist,
wobei der zweite Kühlmittel-Strömungspfad (161A, 162A) innerhalb der zweiten Kühlplatte (160) gebildet ist,
wobei die zweite Kühlplatte (160) eine Dicke von 3 mm bis 10 mm aufweist, und wobei die die zweite Kühlplatte (160) darstellende Keramik Siliciumcarbide, ein Verbundmaterial aus Siliciumcarbid und Silicium oder Aluminiumnitrid ist.

## Revendications

1. Platine (100, 100M) conçue pour supporter sur celle-ci un objet d'inspection (W) ayant un dispositif électronique pressé contre une borne de contact (24a) d'une carte sonde (24) d'un appareil d'inspection (1) en appliquant une charge, et comportant une première plaque de refroidissement (120) comportant une première voie d'écoulement de liquide de refroidissement (123) formée dans la première plaque de refroidissement (120),
une source de chauffage (130) montée sur la première plaque de refroidissement (120) et conçue pour chauffer l'objet d'inspection (W), et
un élément de transmission (150) installé sur la source de chauffage (130) et configuré pour transmettre la lumière émise par la source de chauffage (130) ; la platine (100, 100M) étant **caractérisée par** :
une seconde plaque de refroidissement (160) installée sur l'élément de transmission (150), comportant une surface de placement (160A) conçue pour aspirer l'objet d'inspection (W) et une seconde voie d'écoulement de liquide de refroidissement (161A, 162A), fabriquée en céramique et soumise à un processus de polissage miroir sur la surface de placement (160A) ; et
un film d'absorption de chaleur (195) installé sur une surface inférieure de la seconde plaque de refroidissement (160) et formé par l'application d'une peinture à base d'eau ou d'une poudre céramique contenant de la fluororésine ayant une résistance à l'eau et une résistance à la chaleur,
dans laquelle la surface de placement (160A) de la seconde plaque de refroidissement (160) présente une hauteur maximale (Rmax) de la rugosité de surface comprise entre 0,025 µm et 0,2 µm,
dans laquelle la seconde voie d'écoulement de liquide de refroidissement (161A, 162A) est formée à l'intérieur de la seconde plaque de refroidissement (160),
dans laquelle la seconde plaque de refroidissement (160) a une épaisseur comprise entre 3 mm et 10 mm, et dans laquelle la céramique formant la seconde plaque de refroidissement (160) est du carbure de silicium, un matériau composite de carbure de silicium et de silicium, ou du nitrure d'aluminium.
